# EUROPEAN PATENT SPECIFICATION

(11) **EP 4 177 705 B1**
(45) Date of publication and mention of the grant of the patent: **14.10.2026**
(21) Application number: 21852197.9
(22) Date of filing: 04.08.2021
(51) Int. Cl.: G06F 1/16, C25D 11/24, C25D 11/16, C25D 11/10, C25D 11/08, C23F 3/00, H04M 1/02, H05K 5/04, H05K 5/00, C23F 1/00

(54) **ELECTRONIC DEVICE COMPRISING HOUSING**
ELEKTRONISCHE VORRICHTUNG MIT GEHÄUSE
DISPOSITIF ÉLECTRONIQUE COMPRENANT UN BOÎTIER

(30) Priority: 04.08.2020 KR 20200097648
(43) Date of publication of application: 10.05.2023
(73) Proprietor: Samsung Electronics Co., Ltd., Suwon-si, Gyeonggi-do 16677 (KR)
(72) Inventor: KIM, Jungchul, Suwon-si, Gyeonggi-do 16677 (KR); LEE, Yoonhee, Suwon-si, Gyeonggi-do 16677 (KR); SEOL, Giwon, Suwon-si, Gyeonggi-do 16677 (KR); LEE, Jongsu, Suwon-si, Gyeonggi-do 16677 (KR); HWANG, Yongwook, Suwon-si, Gyeonggi-do 16677 (KR)
(74) Representative: Gulde & Partner
(86) International application number: PCT/KR2021/010214
(87) International publication number: WO 2022/030992

(56) References cited:
- WO-A1-2019/135664
- KR-A- 20120 017 269
- KR-A- 20120 017 269
- KR-A- 20140 112 326
- KR-A- 20200 085 066
- KR-B1- 101 404 127
- US-A1- 2011 287 223
- US-A1- 2020 080 219
- US-A1- 2021 095 388

## Description

### [Technical Field]

Embodiments of the disclosure described herein relate to an electronic device including a housing.

### [Background Art]

A housing of an electronic device may include a metallic material to secure a predetermined stiffness. In addition, the housing may be manufactured to have texture and gloss to provide aesthetics to a user. The texture may be provided by changing the surface roughness of a metallic base material through a blasting process. Furthermore, the gloss may be provided through a physical polishing process. US 2020/080219 A1 provides anodic oxide coatings that provide corrosion resistance to parts having protruding features, such as edges, corners and convex-shaped features. KR 2012 0017269 A discloses improving the manufacturing method of the mobile terminal and mobile terminal, specifically, the surface bonding strength between the plastic substrate member and the metallic coating. WO 2019/135664 A1 provides an apparatus comprising a metal housing.

### [Disclosure]

### [Technical Problem]

In the related art, the texture and gloss of the housing may be implemented by physically processing a surface of the metallic base material through blasting and polishing. For example, the gloss may be increased (high glossy), or the gloss may be minimized (matte) through a blasting process. However, the physical method cannot implement semi-gloss between gloss and matte and/or soft and fine texture.

Embodiments of the disclosure provide electronic device including a housing having semi-gloss between gloss and matte and/or soft and fine texture.

### [Technical Solution]

The invention is set out in the appended set of claims, wherein the figures and respective description relate to advantageous embodiments thereof.

The invention is as set out in claim 1, preferred embodiments being set out in dependent claims 2 to 15.

### [Advantageous Effects]

By performing physical and chemical processes to impart gloss and texture, the electronic device according to the embodiments of the disclosure may include the housing having various gloss and texture, compared to that in the related art. For example, the housing may have semi-gloss and relatively soft and fine texture.

In addition, the disclosure may provide various effects that are directly or indirectly recognized.

### [Description of Drawings]

FIG. 1A is an exploded perspective view of an electronic device according to an embodiment.
FIG. 1B is a perspective view illustrating an unfolded state of the electronic device according to an embodiment.
FIG. 1C is a perspective view illustrating a folded state of the electronic device according to an embodiment.
FIG. 2 is a view illustrating an extrusion process for manufacturing a housing of the electronic device according to an embodiment.
FIG. 3 is a sectional view of a metal housing of the electronic device according to an embodiment.
FIG. 4 is a photo of a section of the metal housing of the electronic device according to an embodiment.
FIG. 5 is a flowchart illustrating a method for manufacturing the housing of the electronic device according to an embodiment.
FIG. 6 is a view illustrating a metal part of the housing in some steps of the method for manufacturing the housing of the electronic device according to an embodiment.
FIG. 7 illustrates photographs of the metal part of the housing in some steps of the method for manufacturing the housing of the electronic device according to an embodiment.

With regard to description of the drawings, identical or similar reference numerals may be used to refer to identical or similar components.

### [Mode for Invention]

Hereinafter, various embodiments of the disclosure may be described with reference to accompanying drawings. Accordingly, those of ordinary skill in the art will recognize that modification, and/or alternative on the various embodiments described herein can be variously made without departing from the scope of the appended claims. In the following description, although numerous features may be designated as optional, it is nevertheless acknowledged that all features defined by claim 1 are not to be read as optional.

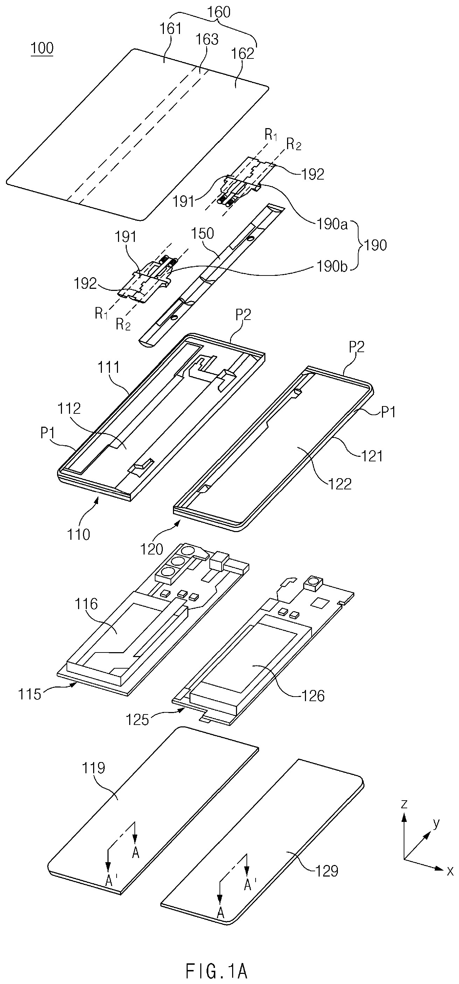

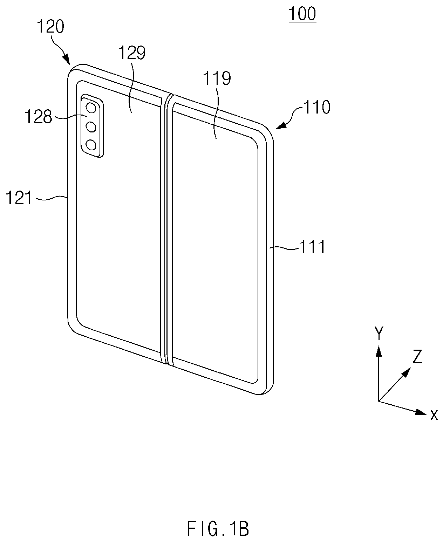

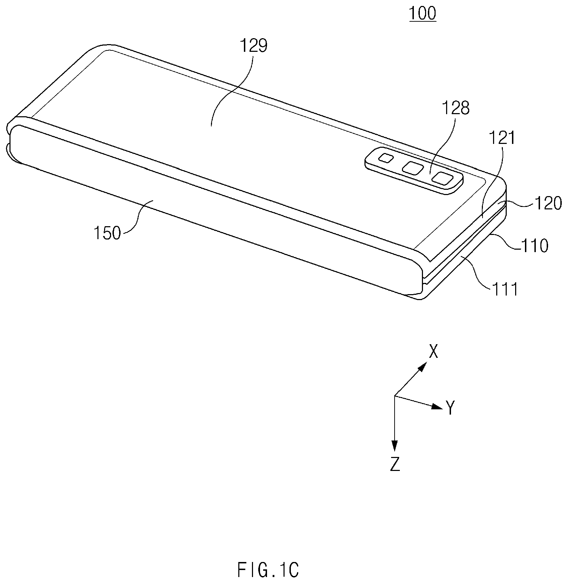

FIG. 1A is an exploded perspective view of an electronic device according to an embodiment. FIG. 1B is a perspective view illustrating an unfolded state of the electronic device according to an embodiment. FIG. 1C is a perspective view illustrating a folded state of the electronic device according to an embodiment.

The foldable electronic device 100 according to an embodiment (hereinafter, referred to as the electronic device) may include an unfolded state (e.g., FIG. 1B) in which a flexible display 160 is substantially flat and a folded state (e.g., FIG. 1C) in which a folding region 163 of the flexible display 160 is curved.

In an embodiment, the electronic device 100 may include a first housing 110, a second housing 120, a hinge structure 190, and the flexible display 160.

In an embodiment, the first housing 110 may include a first plate 112 on which at least a portion of a first flat region 161 of the flexible display 160 is disposed, a first frame 111 that surrounds the first plate 112 and forms a portion of a surface of the electronic device 100, and a first cover 119 that faces the first plate 112 and that is connected with the first frame 111. For example, in the unfolded state, the first frame 111 may form a side surface of the electronic device 100, and the first cover 119 may form a rear surface of the electronic device 100. A space between the first plate 112 and the first cover 119 may be surrounded by the first frame 111.

In an embodiment, a first battery 116 and a first circuit board 115 may be disposed in the first housing 110. Various electronic parts for performing various functions of the electronic device 100 may be disposed on the first circuit board 115. The first circuit board 115 and the first battery 116 may be electrically connected with a second circuit board 125 and a second battery 126 through a flexible circuit board (not illustrated). The first battery 116 may supply power to electronic parts disposed on the first circuit board 115 and the second circuit board 125, and the flexible display 160. In an embodiment, the second housing 120 may include a second plate 122 on which at least a portion of a second flat region 162 of the flexible display 160 is disposed, a second frame 121 that surrounds the second plate 122 and forms a portion of a surface of the electronic device 100, and a second cover 129 that faces the second plate 122 and that is connected with the second frame 121. For example, in the unfolded state, the second frame 121 may form a side surface of the electronic device 100, and the second cover 129 may form a rear surface of the electronic device 100. A space between the second plate 122 and the second cover 129 may be surrounded by the second frame 121.

In an embodiment, the second battery 126 and the second circuit board 125 may be disposed in the second housing 120. Various electronic parts for performing various functions of the electronic device 100 may be disposed on the second circuit board 125. The second circuit board 125 and the second battery 126 may be electrically connected with the first circuit board 115 and the first battery 116 through the flexible circuit board (not illustrated). The second battery 126 may supply power to the electronic parts disposed on the first circuit board 115 and the second circuit board 125, and the flexible display 160.

In an embodiment, the first housing 110 may rotate about a first rotational axis R1, and the second housing 120 may rotate about a second rotational axis R2. As the first housing 110 and the second housing 120 rotate, the electronic device 100 may be folded or unfolded.

In an embodiment, the flexible display 160 may include the first flat region 161 and the second flat region 162 formed to be substantially flat and the folding region 163 deformable to be flat or curved. In an embodiment, the first flat region 161 may be disposed on at least a partial area of the first plate 112. For example, the first flat region 161 may be attached to the first plate 112 and may thus remain flat when the electronic device is folded or unfolded. In an embodiment, the second flat region 162 may be disposed on at least a partial region of the second plate 122. For example, the second flat region 162 may be attached to the second plate 122 and may thus remain flat when the electronic device is folded or unfolded. In an embodiment, the folding region 163 may be formed between the first flat region 161 and the second flat region 162, and at least a portion of the folding region 163 may be disposed on the hinge structure 190. The folding region 163 may be curved in the folded state and may be flat in the unfolded state.

In an embodiment, the hinge structure 190 may connect the first housing 110 and the second housing 120 such that the first housing 110 and the second housing 120 rotate about the first rotational axis R1 and the second rotational axis R2, respectively. In an embodiment, the hinge structure 190 may include a first rotary part 191 configured to rotate about the first rotational axis R1, and a second rotary part 192 configured to rotate about the second rotational axis R2. For example, the first rotary part 191 may be connected to the first plate 112 of the first housing 110. The second rotary part 192 may be connected to the second plate 122 of the second housing 120.

In an embodiment, at least a portion of the hinge structure 190 may be accommodated in a hinge housing 150. The hinge housing 150 may be hidden by the first housing 110 and the second housing 120 in the unfolded state (e.g., FIG. 1B) and may be exposed on the exterior of the electronic device 100 in the folded state (e.g., FIG. 1C).

In various embodiments, the hinge structure 190 may include a first hinge structure 190a and a second hinge structure 190b. The first hinge structure 190a and the second hinge structure 190b may be spaced apart from each other in the direction of the rotational axes R1 and R2.

In an embodiment, when the electronic device 100 is folded or unfolded, the first housing 110, together with the first rotary part 191, may rotate about the first rotational axis R1 by a predetermined angle in a first rotational direction, and the second housing 120, together with the second rotary part 192, may rotate about the second rotational axis R2 by the predetermined angle in a second rotational direction opposite to the first rotational direction.

In various embodiments, the first frame 111 and the first cover 119 of the first housing 110 may have different surface roughnesses. In various embodiments, the second frame 121 and the second cover 129 of the second housing 120 may have different surface roughnesses. In various embodiments, the first cover 119 and the second cover 129 may have a surface roughness of 3 micrometers or less.

In various embodiments, when each of the first housing 110 and the second housing 120 is viewed from above, a long first edge P1 and a relatively short second edge P2 perpendicular to the first edge P1 may be defined. For example, the first edge P1 of the first frame 111 and the first cover 119 may be parallel to the y-axis, the first rotational axis R1, and the second rotational axis R2. For example, the first edge P1 of the second frame 121 and the second cover 129 may be parallel to the y-axis, the first rotational axis R1, and the second rotational axis R2.

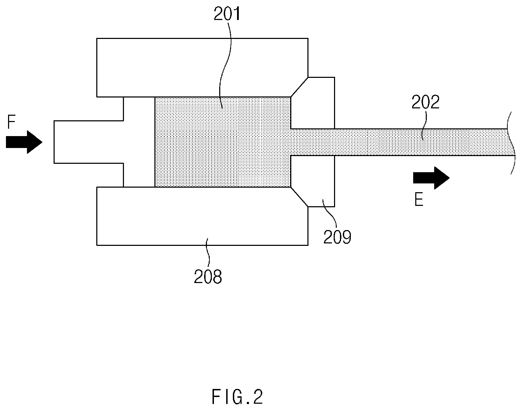

In various embodiments, each of the first housing 110 and the second housing 120 may be manufactured from a metallic base material (e.g., a metallic base material 202 of FIG. 2) that is extruded in the direction in which the first edge P1 extends.

In various embodiments, a camera region 128 through which a camera module is exposed may be formed in at least one of the first cover 119 and the second cover 129. The camera region 128 may include a non-metallic material.

In an embodiment, the housing 110 and 120 may include a metal part formed of a metallic material and a polymer part formed of a polymer material.

FIG. 2 is a view illustrating an extrusion process for manufacturing the metal part of the housing of the electronic device according to an embodiment.

In an embodiment, the metal part of the housing (e.g., the first housing 110 and the second housing 120 of FIGS. 1A to 1C) may be manufactured by processing the metallic base material 202. For example, the housing manufactured from the metallic base material 202 may include at least one of the first frame 111, the second frame 121, the first plate 112, the second plate 122, the first cover 119, and the second cover 129 illustrated in FIGS. 1A to 1C. For example, the camera region 128 of the first cover 119 and the second cover 129 may be excluded.

In an embodiment, the metallic base material 202 may be manufactured through an extrusion process. In the extrusion process, a metallic material may be accommodated in a container 208 and may be pressed to one side. The metallic base material 202 may be manufactured in a predetermined shape as the pressed metallic material passes through a hole of a die 209. At this time, a direction in which the metallic base material 202 is extruded may be defined as an extrusion direction E. The extrusion direction E may be parallel to or different from a pressing direction F.

In an embodiment, the metallic base material 202 may be processed into the first cover 119 and the second cover 129 illustrated in FIG. 1A through a predetermined process. In this case, the extrusion direction E of the metallic base material 202 may be the y-axis direction illustrated in FIG. 1A. In various embodiments, the extrusion direction E of the metallic base material 202 may be a direction parallel to the first rotational axis R1 and the second rotational axis R2 of the electronic device 100. In various embodiments, the extrusion direction E of the metallic base material 202 may be the extension direction (e.g., the long-side direction) of relatively long edges of the first cover 119 and the second cover 129.

In various embodiments, in addition to the first cover 119 and the second cover 129, a metal structure constituting the exterior of the electronic device may be processed from the metallic base material 202. For example, the first frame 111, the second frame 121, and the hinge housing 150 illustrated in FIGS. 1A to 1C may be formed by being processed from the metallic base material 202.

In various embodiments, the metallic base material 202 may be an aluminum alloy having a purity of 80% or more.

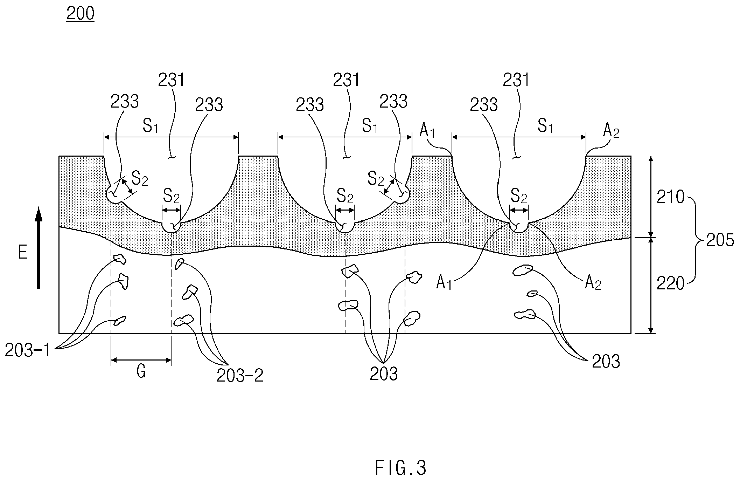

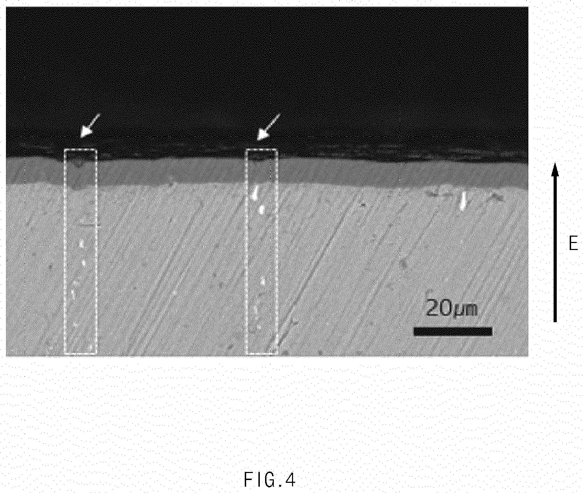

FIG. 3 is a sectional view of the housing of the electronic device according to an embodiment. FIG. 4 is a scanning electron microscopy (SEM) image of the housing of the electronic device according to an embodiment.

FIG. 3 is a schematic diagram schematically illustrating FIG. 4 for a better understanding. FIG. 4 is a photo of a section of the housing.

A surface roughness Ra mentioned below may be a value measured in a non-contact manner. For example, the surface roughness may be a value measured by using a laser measurement device.

In an embodiment, a metal part 205 may include a coating portion 210 (e.g., a coating layer) and a base portion 220. The coating portion 210 may be formed by oxidation of a portion of the metal part 205 that is adjacent to a surface. For example, the coating portion 210 may include aluminum oxide. The base portion 220 may be the remaining metal part other than the coating portion.

In an embodiment, a bumpy structure may be formed on the surface of the metal part 205. For example, the bumpy structure may be formed on the coating portion 210 of the metal part 205. For example, the coating portion 210 may be formed by anodic oxidation of a portion including the bumpy structure after the bumpy structure is formed on the surface of the metal part 205. In various embodiments, the bumpy structure may diffusely reflect light to provide a unique aesthetic sense to a user. The gloss, texture, and/or color of the metal part 205 that forms the exterior of the electronic device 100 may vary depending on the shape and/or structure of the bumpy structure.

The bumpy structure of the coating portion 210 is formed by a first concave portion 231 and a second concave portion 233. The first concave portions 231 have a relatively large size S1, and the second concave portions 233 have a relatively small size S2. The first concave portion 231 and the second concave portion 233 may include a portion in which the surface of the metal part 205 is recessed.

The sizes S1 and S2 of the concave portions 231 and 233 disclosed in the disclosure may be defined as a gap between protruding portions (e.g., A1 and A2 of FIG. 3) continuously extending from the recessed region when a section of the metal part 205 of the housing 200 is viewed. For example, the sizes of the concave portions 231 and 233 may be defined as a gap between the protruding portions A1 and A2 closest to the recessed region.

Referring to the sections of FIGS. 3 and 4, the sizes of the concave portions 231 and 233, when viewed on the section, are defined as a gap between the first protruding portion A1 located on one side and the second protruding portion A2 located on an opposite side.

For example, referring to FIG. 4, the sizes S1 and S2 of the concave portions 231 and 233 may be defined as a straight-line distance connecting the protruding portions A1 and A2 adjacent to the concave portions 231 and 233 when the coating portion 210 is viewed from above. For example, the sizes S1 and S2 of the concave portions 231 and 233 may be defined as the largest of straight-line distances connecting peripheral protruding portions that define a concave portion.

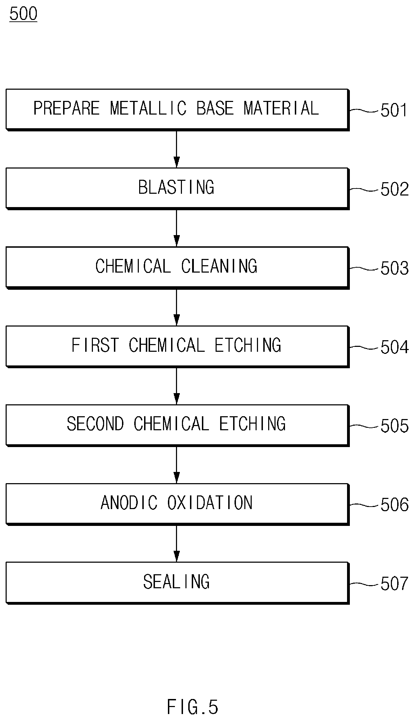

In an embodiment, the first concave portion 231 included in the metal part 205 of the housing 200 may be formed by performing a blasting process (e.g., operation 502 of FIG. 5) on an extruded metallic base material (e.g., the metallic base material 202 of FIG. 2). For example, the blasting process may include spraying ceramic beads to the surface of the metallic base material 202. For example, the size of the first concave portion 231 may vary depending on the size of the ceramic beads colliding with the surface of the metallic base material 202.

The first concave portion 231 has a size of 70 µm or less. When a straight line connecting the peripheral protruding portions of the first concave portion 231 is measured, the largest of the measured distances is 70 µm.

In an embodiment, the metal part 205 of the housing 200 may include an aluminum alloy. In an embodiment, the metal part 205 of the housing 200 may include a metal composite 203. For example, the metal composite 203 may be a material in which aluminum and another metal are physically and/or chemically coupled. In various embodiments, the metal composite 203 may include at least one of FeAl3, CrAl3, Fe3SiAl12, Cr3SiAl12, Mg2Si, Mg(Zn2AlCu), and CrAl7.

In an embodiment, the second concave portion 233 included in the metal part 205 of the housing 200 may be formed by performing an etching process (e.g., operation 504 of FIG. 5) on the metallic base material (e.g., the metallic base material 202 of FIG. 2) on which the first concave portion 231 is formed. For example, the etching process may include dissolving the metal composite 203 included in the metallic base material 202 by using a chemical material. For example, the second concave portion 233 may be formed by dissolution of the metal composite 203 located on the surface of the metallic base material 202. Accordingly, the second concave portion 233 may be formed in the position of the metal composite 203 dissolved through the etching process.

In various embodiments, the second concave portion 233 may be formed in the first concave portion 231. However, without being necessarily limited thereto, the second concave portion 233 may be formed in a region between first concave portions 231. Referring to (b) of FIG. 4, one portion of the second concave portion 233 may be formed in the first concave portion 231, and another portion may be formed between the first concave portions 231.

In various embodiments, the second concave portion 233 may have a size of 3 µm or less. For example, when a straight line connecting the peripheral protruding portions A1 and A2 of the second concave portion 233 is measured, the largest of the measured distances may be 3 µm or less.

In the housing 200 according to an embodiment, a second concave portion 233 having a size that cannot be implemented by blasting may be formed. Beads sprayed in the blasting may be too large to form a fine bumpy structure such as the second concave portion 233. In contrast, in the housing 200 according to an embodiment, a fine bumpy structure within about 500% of the size of the metal composite 203 may be formed through a chemical method. This may provide unique texture and gloss.

The second concave portion 233 is formed to be larger than the metal composite 203. For example, in the etching process, a chemical material may dissolve the metal composite 203 and the surrounding metal together. In various embodiments, the size of the second concave portion 233 may be 500% or less of the size of the metal composite 203.

In various embodiments, one of the second concave portions 233 may be arranged with another one adjacent thereto at an interval of 100 µm or less.

In an embodiment, at least a portion of the metal composite 203 may be located in the base portion 220. For example, the metal composites 203 located on the surface of the metallic base material (e.g., the metallic base material 202 of FIG. 2) may be removed as the etching process (e.g., operation 504 of FIG. 5) is performed, and the metal composite 203 distributed in the metallic base material 202 may be located in the base portion 220. In various embodiments, a portion of the metal composite 203 may be located in the coating portion 210.

The sections illustrated in FIGS. 3 and 4 may be, for example, sections that include a vector in the extrusion direction of the metal part 205 (e.g., the y-axis direction of FIG. 1A) and a vector in a direction from the inside toward the outside of the electronic device 100 (e.g., the z-axis direction of FIG. 1A).

In an embodiment, the metal composites 203 may be arranged in a direction substantially parallel to the extrusion direction E. For example, in FIGS. 3 and 4, the metal composites 203 may be aligned with the second concave portion 233 adjacent thereto in a direction substantially parallel to the extrusion direction E.

For example, when viewed in the section of the metal part 205, first metal composites 203-1 distributed in the extrusion direction from one of the second concave portions 233 and second metal composites 203-2 distributed in the extrusion direction from another one of the second concave portions 233 may be defined.

In various embodiments, the first metal composites 203-1 and the second metal composites 203-2 may be spaced apart from each other by a gap of 100 µm or less. For example, the first metal composites 203-1 and the second metal composites 203-2 may be spaced apart from each other by a gap of 100 µm or less when measured in a direction perpendicular to the extrusion direction.

In an embodiment, the surface roughness Ra of the metal part of the housing may be 3 µm or less.

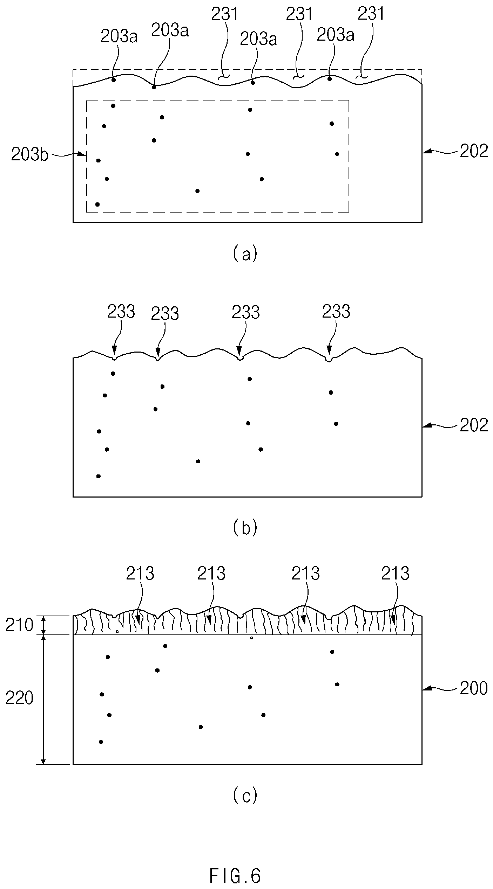

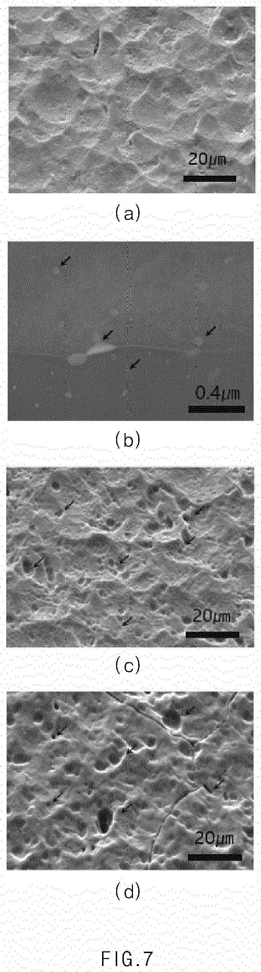

FIG. 5 is a flowchart illustrating a method for manufacturing the housing of the electronic device according to an embodiment. FIG. 6 is a view illustrating the metal part of the housing in some steps of the method for manufacturing the housing of the electronic device according to an embodiment. FIG. 7 illustrates photographs of the metal part of the housing in some steps of the method for manufacturing the housing of the electronic device according to an embodiment.

Referring to FIG. 5, the manufacturing method may include an operation 501 of preparing a metallic base material, an operation 502 of performing blasting on the metallic base material, an operation 503 of chemically cleaning the blasted metallic base material, an operation 504 of performing first chemical etching on the chemically cleaned metallic base material, an operation 505 of performing second chemical etching after the first chemical etching, an anodic oxidation operation 506, and a sealing operation 507.

In an embodiment, in the operation of preparing the metallic base material (e.g., the metallic base material 202 of FIG. 2), the metallic base material 202 may include an aluminum alloy having a purity of 80% or more. The purity may be measured in wt% or mole%. As illustrated in FIG. 2, the metallic base material 202 may be manufactured through an extrusion process. In various embodiments, the metallic base material 202 may be processed in a predetermined shape. For example, the metallic base material 202 may be manufactured by performing at least one of press, CNC machining, casting, and extrusion.

In an embodiment, in the operation 501 of performing the blasting on the metallic base material 202, a bumpy structure may be formed on a surface of the metallic base material 202. For example, the bumpy structure formed through the blasting operation 501 may be the first concave portion 231 illustrated in FIG. 3. The blasting operation 501 may include an operation of spraying ceramic beads and/or STS to a metal surface. In various embodiments, the ceramic beads and/or STS may be sprayed through a pneumatic sprayer. For example, referring to (a) of FIG. 6 and (a) of FIG. 7, the surface of the metallic base material 202 may be concavely recessed by collision with the sprayed beads. The blasting operation 501 may be performed such that the surface roughness Ra of the metallic base material 202 ranges from 2 µm to 5 µm. In various embodiments, the blasting operation 501 may be performed by pneumatically spraying B205 ceramic beads (Zirconia 68%, Glassy 32%). The spray pressure may be 2.0 bar, and the distance between the sprayer and the metallic base material 202 may range from 17 cm to 20 cm.

In various embodiments, the manufacturing method 500 may further include a physical polishing operation 502 of physically polishing the metallic base material 202 before the blasting operation 501. For example, the physical polishing operation may include an operation of polishing the metallic base material 202. For example, an oxide film formed on the surface of the metallic base material 202 may be removed in the polishing process.

In an embodiment, foreign matter on the surface of the metallic base material 202 may be removed through the operation 503 of chemically cleaning the blasted metallic base material 202. The chemical cleaning operation 530 may be chemically performed using a chemical material without applying an electric current. In various embodiments, the chemical material may include an acidic material including at least one of an alkaline surfactant and nitric acid, and/or an alkaline material. In various embodiments, the chemical cleaning operation 503 may be performed for 120 seconds to 240 seconds at a temperature range of 40°C to 60°C. In various embodiments, the chemical material may have a concentration of 40 g/L to 120 g/L.

In an embodiment, in the operation 504 of performing the first chemical etching on the chemically cleaned metallic base material 202, a portion of a metal composite 203 included in the metallic base material 202 may be dissolved by a first etching solution. For example, the first chemical etching operation 504 may be performed by immersing the metallic base material 202 in the first etching solution. For example, referring to (b) of FIG. 6 and (c) of FIG. 7, a portion 203a of the metal composite 203 located on the surface of the metallic base material 202 may be dissolved to form a second concave portion 233 (e.g., the second concave portion 233 of FIG. 3). Metal composites 203b located in the metallic base material 202 may not be dissolved.

In various embodiments, the first etching solution may include caustic soda. For example, the caustic soda may have a concentration of 20 g/L to 100 g/L. In various embodiments, the first chemical etching operation may be performed for 10 seconds to 120 seconds at a temperature range of 20°C to 100°C. For example, the first chemical etching operation 504 may be performed by immersing the metallic base material 202 in the first etching solution. In an embodiment, since the second concave portion 233 is formed after the first chemical etching operation 504 is performed, the surface roughness Ra may be increased, compared to that before the first chemical etching operation 504 is performed. For example, the surface roughness may range from 2.7 µm to 3.1 µm. In various embodiments, the first etching solution may include an acidic material including at least one of phosphoric acid, hydrofluoric acid, sulfuric acid, and nitric acid, and/or an alkaline material.

In general, an etching operation using an etching solution including caustic soda may be performed to remove an oxide film formed on a surface of a metallic base material. In contrast, the first chemical etching operation 504 of the manufacturing method 500 according to an embodiment may be an operation for forming a bumpy structure (e.g., the second concave portion 233) on the surface of the metallic base material 202.

The manufacturing method 500 and the housing 200 manufactured thereby according to an embodiment may implement a bumpy structure (e.g., the second concave portion 233) having a size that cannot be implemented by the blasting operation 502. The size of the beads sprayed in the blasting operation may have a physical limit of 10 µm or more. According to an embodiment, the second concave portion 233 having a smaller size than the beads may be formed by chemically dissolving the metal composite 203. For example, the second concave portion 233 having a size of 3 µm or less may be formed in the housing 200.

In an embodiment, in the second chemical etching operation 505 after the first chemical etching operation, a portion of the bumpy structure on the surface of the metallic base material 202 may be dissolved by a second etching solution. For example, when (c) and (d) of FIG. 7 are compared with each other, the surface roughness of the metallic base material 202 may be decreased as the second chemical etching operation 505 is performed. In an embodiment, after the second chemical etching operation 505 is performed, the surface roughness may range from 2 µm to 2.5 µm. The second etching solution may include phosphoric acid, nitric acid, and/or sulfuric acid. In various embodiments, the second chemical etching operation 505 may be performed for 20 seconds to 60 seconds at a temperature range of 80°C to 120°C. For example, the second chemical etching operation 505 may be performed by immersing the metallic base material 202 in the second etching solution.

In an embodiment, referring to (c) of FIG. 6, in the anodic oxidation operation 506, a film 210 may be formed on the surface of the metallic base material 202. For example, the film may be referred to as the coating portion illustrated in FIG. 3. For example, the film 210 may include oxide of a metallic material included in the metallic base material 202. For example, the metallic base material 202 may include an aluminum alloy, and the film 210 may include aluminum oxide. The anodic oxidation operation 506 may be performed by immersing the metallic base material 202 in any solution capable of anodic oxidation. For example, the solution capable of anodic oxidation may include an acidic solution including at least one of sulfuric acid, oxalic acid, and chromic acid and an alkaline solution based on sodium hydroxide. In various embodiments, the anodic oxidation operation may be performed by applying a voltage of +5 V to +20 V to the immersed metallic base material 202. In various embodiments, the anodic oxidation operation may be performed for 10 minutes to 120 minutes at a temperature range of 5°C to 25°C.

In various embodiments, referring to (c) of FIG. 6, a pore 213 may be formed in the film 210 of the metallic base material 202 after the anodic oxidation operation is performed. A dye for coloring may be injected into the pore 213.

In an embodiment, in the sealing operation 507, the pore 213 into which the dye is injected may be sealed. In various embodiments, the sealing operation 507 may be performed for 10 minutes to 120 minutes at a temperature range of 25°C to 110°C in a state in which the metallic base material 202 is immersed in a sealing solution.

According to a comparative example in the related art, a blasting process may be performed on the housing to adjust the surface roughness and impart texture. According to the comparative example, gloss may be increased (high glossy) through an additional physical polishing process, or gloss may be minimized (matte) through a blasting process. According to this example, the texture and gloss of the housing may be physically implemented through blasting and polishing. Therefore, an electronic device according to the comparative example cannot implement relatively soft and fine texture and/or semi-gloss.

According to the housing 200 of the electronic device and the method 500 for manufacturing the housing 200 according to an embodiment, relatively soft and fine texture and/or semi-gloss may be implemented by physically forming the first concave portion 231 on the surface of the metallic base material 202 through the blasting operation 502 and chemically forming the second concave portion 233 on the surface of the metallic base material 202 through the first chemical etching operation 504.

It should be appreciated that various embodiments of the disclosure and the terms used therein are not intended to limit the technological features set forth herein to particular embodiments and include various changes, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

According to the situation, the expression "adapted to or configured to" used in this disclosure may be used interchangeably with, for example, the expression "suitable for", "having the capacity to", "adapted to", "made to", "capable of , or "designed to" in hardware or software. The expression "a device configured to" may mean that the device is "capable of" operating together with another device or other components. For example, a "processor set to (or configured to) perform A, B, and C" may mean a dedicated processor (e.g., an embedded processor) for performing corresponding operations or a generic-purpose processor (e.g., a CPU or an AP) that performs corresponding operations by executing one or more programs stored in a memory device (e.g., the memory 130).

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. The "module" may be implemented mechanically or electronically and may include, for example, an application-specific integrated circuit (ASIC) chip, field-programmable gate arrays (FPGAs), or a programmable-logic device for performing some operations, which are known or will be developed.

At least a part of an apparatus (e.g., modules or functions thereof) or a method (e.g., operations) according to various embodiments may be implemented by instructions stored in computer-readable storage media (e.g., the memory 130) in the form of a program module. The instructions, when executed by a processor (e.g., the processor 120), may cause the processor to perform functions corresponding to the instructions. The computer-readable storage media may include a hard disk, a floppy disk, a magnetic media (e.g., a magnetic tape), an optical media (e.g., CD-ROM, DVD, magneto-optical media (e.g., a floptical disk)), an embedded memory, and the like. The instructions may include a code made by a compiler or a code executable by an interpreter.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (100) comprising:
a housing (110, 120) including a metal part (205) including a first metal; and
a display (160) disposed in the housing (110, 120) and visually exposed through a first surface of the electronic device (100),
wherein the metal part (205) includes a first portion (220) including the first metal and a second portion (210) formed on a surface of the first portion (220), the second portion (210) including metal oxide including the first metal,
wherein the second portion (210) forms a second surface of the electronic device (100),
wherein a bumpy structure including a plurality of first concave portions (231) and a plurality of second concave portions (233) recessed toward the first portion (220) is formed on the second portion (210),
**characterized in that** the first concave portions (231) have a relatively large size (S1) of 70 micrometers or less, and
wherein the second concave portions (233) have a relatively small size (S2) of 3 micrometers or less, wherein the second concave portions (233) are formed to be larger than at least some of a plurality of metal composites (203),
wherein the sizes of the first and second concave portions are defined as a gap between a first protruding portion (A1) located on one side of a concave portion and a second protruding portion (A2) located on an opposite side of the concave portion.

2. The electronic device (100) of claim 1, wherein the second portion (210) has a surface roughness of 3 micrometers or less.

3. The electronic device (100) of claim 1 or 2, wherein the metal part (205) includes the plurality of metal composites (203) in which the first metal and a second metal different from the first metal are chemically and/or physically coupled, and
wherein the plurality of metal composites (203) are arranged along a virtual straight line extending in a first direction from each of the plurality of second concave portions (233).

4. The electronic device (100) of claim 1, wherein one of the plurality of second concave portions (233) is spaced apart from another adjacent one by a gap (G) of 100 micrometers or less when measured along a surface of the second portion (210).

5. The electronic device (100) of claim 4, wherein the metal part (205) includes the plurality of metal composites (203) in which the first metal and a second metal different from the first metal are chemically and/or physically coupled,
wherein the plurality of metal composites (203) include a first metal composite (203-1) aligned in a first direction and a second metal composite (203-2) aligned in the first direction, and
wherein a gap between the first metal composite (203-1) and the second metal composite (203-2) is 100 micrometers or less when measured in a direction perpendicular to the first direction.

6. The electronic device (100) of claim 5, wherein the at least some of the plurality of metal composites (203) are located in the first portion (220).

7. The electronic device (100) of claim 5, wherein the at least some of the plurality of metal composites (203) have a size of 0.6 micrometers or less.

8. The electronic device (100) of any one of claims 3 and 5, wherein when the electronic device (100) is viewed from above, the metal part (205) includes a first edge (P1) extending in a second direction by a first length and a second edge (P2) extending in a direction perpendicular to the second direction by a second length shorter than the first length, and
wherein the first direction is parallel to the second direction.

9. The electronic device (100) of any one of claims 3 and 5, wherein the first direction is parallel to an extrusion direction (E) of the metal part (205).

10. The electronic device (100) of any one of the preceding claims, wherein a pore (213) extending in a direction from a surface toward the first portion (220) is formed in the second portion (210), and
wherein a dye is accommodated in the pore (213).

11. The electronic device (100) of any one of the preceding claims, wherein at least some of the plurality of second concave portions (233) are located in the first concave portion (231).

12. The electronic device (100) of any one of the preceding claims, wherein the metal part (205) includes the plurality of metal composites (203) in which the first metal and a second metal different from the first metal are chemically and/or physically coupled, and
wherein the second concave portion (233) is formed by dissolution of a part of the plurality of metal composites (203).

13. The electronic device (100) of claim 1, wherein the first metal includes aluminum, and
wherein the second portion (210) is a coating layer including aluminum oxide.

14. The electronic device (100) of any one of claims 3 and 12, wherein the metal composites (203) include at least one of FeAl3, CrAl3, Fe3SiAl12, Cr3SiAl12, Mg2Si, Mg(Zn2AlCu), and CrAl7.

15. The electronic device (100) of any one of the preceding claims, wherein the housing (110, 120) includes a first region (119, 129) configured to form one portion of a surface of the electronic device (100) and having a first surface roughness and a second region (111, 121) configured to form another portion of the surface of the electronic device (100) and having a second surface roughness.

## Patentansprüche

1. Elektronische Vorrichtung (100), umfassend:
ein Gehäuse (110, 120) mit einem Metallteil (205), das ein erstes Metall enthält; und
eine Anzeige (160), die in dem Gehäuse (110, 120) angeordnet ist und durch eine erste Oberfläche der elektronischen Vorrichtung (100) visuell freiliegt,
wobei das Metallteil (205) einen ersten Abschnitt (220), der das erste Metall enthält, und einen zweiten Abschnitt (210) umfasst, der auf einer Oberfläche des ersten Abschnitts (220) ausgebildet ist, wobei der zweite Abschnitt (210) ein Metalloxid enthält, das das erste Metall enthält,
wobei der zweite Abschnitt (210) eine zweite Oberfläche der elektronischen Vorrichtung (100) bildet,
wobei auf dem zweiten Abschnitt (210) eine holprige Struktur mit einer Vielzahl von ersten konkaven Abschnitten (231) und einer Vielzahl von zweiten konkaven Abschnitten (233), die in Richtung des ersten Abschnitts (220) vertieft sind, ausgebildet ist,
**dadurch gekennzeichnet, dass** die ersten konkaven Abschnitte (231) eine relativ große Größe (S1) von 70 Mikrometern oder weniger aufweisen, und
wobei die zweiten konkaven Abschnitte (233) eine relativ kleine Größe (S2) von 3 Mikrometern oder weniger aufweisen, wobei die zweiten konkaven Abschnitte (233) so ausgebildet sind, dass sie größer sind als zumindest einige einer Vielzahl von Metallverbundstoffen (203),
wobei die Größen der ersten und der zweiten konkaven Abschnitte als Spalt zwischen einem ersten vorstehenden Abschnitt (A1), der sich auf einer Seite eines konkaven Abschnitts befindet, und einem zweiten vorstehenden Abschnitt (A2), der sich auf einer gegenüberliegenden Seite des konkaven Abschnitts befindet, definiert sind.

2. Elektronische Vorrichtung (100) nach Anspruch 1, wobei der zweite Abschnitt (210) eine Oberflächenrauheit von 3 Mikrometern oder weniger aufweist.

3. Elektronische Vorrichtung (100) nach Anspruch 1 oder 2, wobei das Metallteil (205) die Vielzahl von Metallverbundstoffen (203) umfasst, in denen das erste Metall und ein vom ersten Metall verschiedenes zweites Metall chemisch und/oder physikalisch gekoppelt sind, und
wobei die Vielzahl von Metallverbundstoffen (203) entlang einer virtuellen Geraden angeordnet sind, die sich in einer ersten Richtung von jedem der Vielzahl von zweiten konkaven Abschnitten (233) erstreckt.

4. Elektronische Vorrichtung (100) nach Anspruch 1, wobei einer der Vielzahl von zweiten konkaven Abschnitten (233) von einem weiteren benachbarten durch einen Spalt (G) von 100 Mikrometern oder weniger beabstandet ist, gemessen entlang einer Oberfläche des zweiten Abschnitts (210).

5. Elektronische Vorrichtung (100) nach Anspruch 4, wobei das Metallteil (205) die Vielzahl von Metallverbundstoffen (203) umfasst, in denen das erste Metall und ein vom ersten Metall verschiedenes zweites Metall chemisch und/oder physikalisch gekoppelt sind,
wobei die Vielzahl von Metallverbundstoffen (203) einen ersten Metallverbundstoff (203-1), das in einer ersten Richtung ausgerichtet ist, und einen zweiten Metallverbund (203-2), der in der ersten Richtung ausgerichtet ist, umfassen, und
wobei ein Spalt zwischen dem ersten Metallverbundstoff (203-1) und dem zweiten Metallverbundstoff (203-2) 100 Mikrometer oder weniger beträgt, gemessen in einer Richtung senkrecht zur ersten Richtung.

6. Elektronische Vorrichtung (100) nach Anspruch 5, wobei sich die zumindest einigen der Vielzahl von Metallverbundstoffen (203) im ersten Abschnitt (220) befinden.

7. Elektronische Vorrichtung (100) nach Anspruch 5, wobei die zumindest einigen der Vielzahl von Metallverbundstoffen (203) eine Größe von 0,6 Mikrometer oder weniger aufweisen.

8. Elektronische Vorrichtung (100) nach einem der Ansprüche 3 und 5, wobei, wenn die elektronische Vorrichtung (100) von oben betrachtet wird, das Metallteil (205) eine erste Kante (P1), die sich in einer zweiten Richtung um eine erste Länge erstreckt, und eine zweite Kante (P2) umfasst, die sich in einer Richtung senkrecht zur zweiten Richtung um eine zweite Länge erstreckt, die kürzer ist als die erste Länge, und
wobei die erste Richtung parallel zur zweiten Richtung verläuft.

9. Elektronische Vorrichtung (100) nach einem der Ansprüche 3 und 5, wobei die erste Richtung parallel zu einer Extrusionsrichtung (E) des Metallteils (205) verläuft.

10. Elektronische Vorrichtung (100) nach einem der vorstehenden Ansprüche, wobei in dem zweiten Abschnitt (210) eine Pore (213) ausgebildet ist, die sich in einer Richtung von einer Oberfläche zu dem ersten Abschnitt (220) erstreckt, und
wobei in der Pore (213) ein Farbstoff aufgenommen ist.

11. Elektronische Vorrichtung (100) nach einem der vorstehenden Ansprüche, wobei sich zumindest einige der Vielzahl von zweiten konkaven Abschnitten (233) in dem ersten konkaven Abschnitt (231) befinden.

12. Elektronische Vorrichtung (100) nach einem der vorstehenden Ansprüche, wobei das Metallteil (205) die Vielzahl von Metallverbundstoffen (203) umfasst, in denen das erste Metall und ein vom ersten Metall verschiedenes zweites Metall chemisch und/oder physikalisch gekoppelt sind, und
wobei der zweite konkave Abschnitt (233) durch Auflösen eines Teils der Vielzahl von Metallverbundstoffen (203) gebildet wird.

13. Elektronische Vorrichtung (100) nach Anspruch 1, wobei das erste Metall Aluminium umfasst, und wobei der zweite Abschnitt (210) eine Beschichtungsschicht ist, die ein Aluminiumoxid enthält.

14. Elektronische Vorrichtung (100) nach einem der Ansprüche 3 und 12, wobei die Metallverbundstoffe (203) mindestens eines von FeAl3, CrAl3, Fe3SiAl12, Cr3SiAl12, Mg2Si, Mg(Zn2AlCu) und CrAl7 umfassen.

15. Elektronische Vorrichtung (100) nach einem der vorstehenden Ansprüche, wobei das Gehäuse (110, 120) einen ersten Bereich (119, 129), der zum Bilden eines Abschnitts einer Oberfläche der elektronischen Vorrichtung (100) konfiguriert ist und eine erste Oberflächenrauheit aufweist, und einen zweiten Bereich (111, 121) umfasst, der zum Bilden eines weiteren Abschnitts der Oberfläche der elektronischen Vorrichtung (100) konfiguriert ist und eine zweite Oberflächenrauheit aufweist.

## Revendications

1. Dispositif électronique (100) comprenant :
un boîtier (110, 120) comprenant une partie métallique (205) comprenant un premier métal ; et
un affichage (160) disposé dans le boîtier (110, 120) et exposé visuellement à travers une première surface du dispositif électronique (100),
dans lequel la partie métallique (205) comprend une première partie (220) comprenant le premier métal et une seconde partie (210) formée sur une surface de la première partie (220), la seconde partie (210) comprenant un oxyde métallique comprenant le premier métal,
dans lequel la seconde partie (210) forme une seconde surface du dispositif électronique (100),
dans lequel une structure bosselée comprenant une pluralité de premières parties concaves (231) et une pluralité de secondes parties concaves (233) en retrait vers la première partie (220) est formée sur la seconde partie (210),
**caractérisé en ce que** les premières parties concaves (231) ont une taille relativement grande (S1) de 70 micromètres ou moins, et
dans lequel les secondes parties concaves (233) ont une taille relativement petite (S2) de 3 micromètres ou moins, dans lequel les secondes parties concaves (233) sont formées de manière à être plus grandes qu'au moins certains d'une pluralité de composites métalliques (203),
dans lequel les tailles des premières et secondes parties concaves sont définies comme un écart entre une première partie saillante (A1) située d'un côté d'une partie concave et une seconde partie saillante (A2) située d'un côté opposé de la partie concave.

2. Dispositif électronique (100) selon la revendication 1, dans lequel la seconde partie (210) a une rugosité de surface de 3 micromètres ou moins.

3. Dispositif électronique (100) selon la revendication 1 ou 2, dans lequel la partie métallique (205) comprend la pluralité de composites métalliques (203) dans lesquels le premier métal et un second métal différent du premier métal sont couplés chimiquement et/ou physiquement, et
dans lequel la pluralité de composites métalliques (203) est agencée le long d'une ligne droite virtuelle s'étendant dans une première direction à partir de chacune de la pluralité de secondes parties concaves (233).

4. Dispositif électronique (100) selon la revendication 1, dans lequel l'une de la pluralité de secondes parties concaves (233) est espacée d'une autre partie adjacente par un écart (G) de 100 micromètres ou moins lorsqu'il est mesuré le long d'une surface de la seconde partie (210).

5. Dispositif électronique (100) selon la revendication 4, dans lequel la partie métallique (205) comprend la pluralité de composites métalliques (203) dans lesquels le premier métal et un second métal différent du premier métal sont couplés chimiquement et/ou physiquement,
dans lequel la pluralité de composites métalliques (203) comprend un premier composite métallique (203-1) aligné dans une première direction et un second composite métallique (203-2) aligné dans la première direction, et
dans lequel un écart entre le premier composite métallique (203-1) et le second composite métallique (203-2) est de 100 micromètres ou moins lorsqu'il est mesuré dans une direction perpendiculaire à la première direction.

6. Dispositif électronique (100) selon la revendication 5, dans lequel au moins certains de la pluralité de composites métalliques (203) sont situés dans la première partie (220).

7. Dispositif électronique (100) selon la revendication 5, dans lequel au moins certains de la pluralité de composites métalliques (203) ont une taille de 0,6 micromètre ou moins.

8. Dispositif électronique (100) selon l'une quelconque des revendications 3 et 5, dans lequel, lorsque le dispositif électronique (100) est vu de dessus, la partie métallique (205) comprend un premier bord (P1) s'étendant dans une seconde direction sur une première longueur et un second bord (P2) s'étendant dans une direction perpendiculaire à la seconde direction sur une seconde longueur plus courte que la première longueur, et
dans lequel la première direction est parallèle à la seconde direction.

9. Dispositif électronique (100) selon l'une quelconque des revendications 3 et 5, dans lequel la première direction est parallèle à une direction d'extrusion (E) de la partie métallique (205).

10. Dispositif électronique (100) selon l'une quelconque des revendications précédentes, dans lequel un pore (213) s'étendant dans une direction depuis une surface vers la première partie (220) est formé dans la seconde partie (210), et
dans lequel un colorant est logé dans le pore (213).

11. Dispositif électronique (100) selon l'une quelconque des revendications précédentes, dans lequel au moins certaines de la pluralité de secondes parties concaves (233) sont situées dans la première partie concave (231).

12. Dispositif électronique (100) selon l'une quelconque des revendications précédentes, dans lequel la partie métallique (205) comprend la pluralité de composites métalliques (203) dans lesquels le premier métal et un second métal différent du premier métal sont couplés chimiquement et/ou physiquement, et
dans lequel la seconde partie concave (233) est formée par dissolution d'une partie de la pluralité de composites métalliques (203).

13. Dispositif électronique (100) selon la revendication 1, dans lequel le premier métal comprend de l'aluminium, et dans lequel la seconde partie (210) est une couche de revêtement comprenant de l'oxyde d'aluminium.

14. Dispositif électronique (100) selon l'une quelconque des revendications 3 et 12, dans lequel les composites métalliques (203) comprennent au moins l'un parmi FeAl3, CrAl3, Fe3SiAl12, Cr3SiAl12, Mg2Si, Mg(Zn2AlCu) et CrAl7.

15. Dispositif électronique (100) selon l'une quelconque des revendications précédentes, dans lequel le boîtier (110, 120) comprend une première région (119, 129) configurée pour former une partie d'une surface du dispositif électronique (100) et ayant une première rugosité de surface et une seconde région (111, 121) configurée pour former une autre partie de la surface du dispositif électronique (100) et ayant une seconde rugosité de surface.
